(19) Europäisches Patentamt
European Patent Office
Office européen des brevets

(11) **EP 4 386 809 A1**

(12) **EUROPEAN PATENT APPLICATION**

(43) Date of publication:
**19.06.2024 Bulletin 2024/25**

(21) Application number: **23215840.2**

(22) Date of filing: **12.12.2023**

(51) International Patent Classification (IPC):
***H01J 37/05*** (2006.01)  ***H01J 37/244*** (2006.01)
***H01J 37/28*** (2006.01)

(52) Cooperative Patent Classification (CPC):
**H01J 37/05; H01J 37/244;** H01J 2237/055;
H01J 2237/057; H01J 2237/24485; H01J 2237/28;
H01J 2237/2802

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.12.2022 US 202263432581 P**

(71) Applicant: **Gatan Inc.**
**Pleasanton, CA 94588 (US)**

(72) Inventors:
• **TREVOR, Colin Geoffrey**
**Pleasanton, 94566 (US)**
• **BARFELS, Melanie**
**Concord, 94518 (US)**

(74) Representative: **Zacco Denmark A/S**
**Arne Jacobsens Allé 15**
**2300 Copenhagen S (DK)**

(54) **SYSTEM AND METHOD OF OPERATING AN ELECTRON ENERGY LOSS SPECTROMETER**

(57)     A system and method for compensating for chromatic aberration in a transmission electron microscope used with an electron energy level spectrometer is described. The method adjusts via a controller (230) an electrostatic or magnetic lens (211, 212) located between an electron microscope (201) and a bending magnet (213) to focus the electron microscope beam at electron energy levels under observation.

Figure 1

# Description

## CROSS REFERENCE TO RELATED APPLICATION

This application claims priority to and incorporates by reference in its entirety United States provisional patent application number 63/432,581, filed on December 14, 2022 and titled System and Method of Operating an Electron Energy Loss Spectrometer.

## BACKGROUND OF THE INVENTION

When Electron Energy Loss Spectroscopy (EELS) spectrometers are used with very low camera lengths on a scanning or transmission electron microscope (S/TEM) so as to allow large collection angles, a parasitic defocus occurs due to the objective lens of the S/TEM having chromatic aberration, which is a focal length that varies with electron energy.

Within a single spectrum this effect can be corrected by tilting the spectrum plane. This can be achieved by adjusting a lens located just upstream of the slit but this is complex to use as it is not typically pure in function.

When performing dual EELS, which is shifting between two energies that are typically, but not necessarily limited to, the zero loss portion of the spectrum and an elemental edge portion of the spectrum, and with a high dispersion so as to allow observation of high resolution of the zero loss portion and the elemental edge portion, the defocus within a single spectrum is small but the defocus between the zero loss and the edge can be large if a very short camera length is used. In this case only the defocus between spectra needs to be corrected not the defocus in a single spectrum. This can be achieved by an additional focusing element upstream of the bending magnet.

## BRIEF DESCRIPTION OF THE DRAWINGS

Figure 1 is a diagram of an exemplary electron energy loss spectrometer;
Figure 2 a diagram showing the effect of focal length change with electron energy level;
Figure 3 is an exemplary zero loss spectrum portion;
Figure 4 is an exemplary elemental edge spectrum portion;
Figure 5 is an exemplary controller; and
Figure 6 is a flow diagram of an exemplary process.

## DETAILED DESCRIPTION

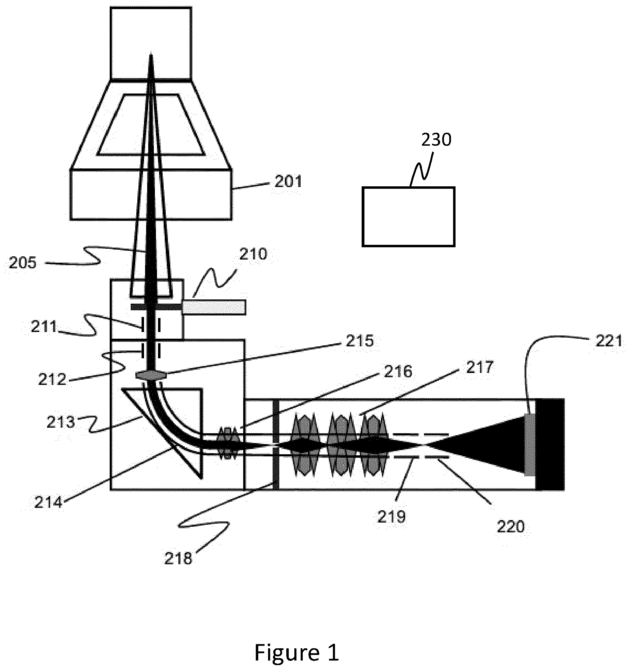

With reference to Figure 1, there is shown a beam 205 emerging from a transmission electron microscope 201 entering the spectrometer through an aperture 210. An electrostatic lens system 211, 212 and 219, 220 is respectively added to the prior art device before and after the bending magnet drift tube 214. These lenses are adjusted as a function of the bending magnet drift tube voltage and prism energy offset so that the focal length of the spectrometer varies to compensate for the change in position of the final crossover in the microscope (i.e. the focused cross-over within the microscope that is the object for the spectrometer) so as no defocusing occurs at the detector 221. Reference items 220 and 221 depict grounded tubes and a grounded detector and 212, 219 are voltage biased lens elements.

In a further embodiment, the isolated drift tube 214 is extended throughout the entire optics 216, 217, not just the bending magnet 214, so that the range of electron energies in all the optics is constant and no defocusing occurs from chromatic effects in the spectrometer.

In a further embodiment, the electrostatic lenses 212, 219 are round electrostatic lenses. In a further embodiment the electrostatic lenses are located at the start 212 and end 219 of the bending magnet drift tube. In the case of the EEL spectrometer that can serve as an Imaging Energy Filter as well, the energy selecting slit 218 is floated at the voltage V, to prevent electrostatic lens effects around the slit. In further embodiments, there are fewer or more than two electrostatic lenses. In a further embodiment, multi-pole lenses are used instead of round lenses. In further embodiments magnetic lenses are used instead of electrostatic lenses.

In a further embodiment, an intermediate focused spectrum is formed in the system.

An energy-selecting slit 218 is located at the focused spectrum with a width in eV equal to the field of view in eV to be detected by the detector. The slit is imaged by following optics 217 to match the size of the detector 221 in the dispersion direction, so that electrons that are outside of the detector field of view cannot proceed in the spectrometer past the slit. These electrons are cleanly and sharply trapped by the slit and can therefore no longer scatter off of drift tube walls.

The slit width may be adjustable with varying dispersion such that the slit always closely matches the field of view in eV to be detected by the detector. The slit is floated at a controllable electrostatic bias potential.

Controller 230 may control without limitation any of the above-described components and may perform, without limitation, any processes or methods described herein.

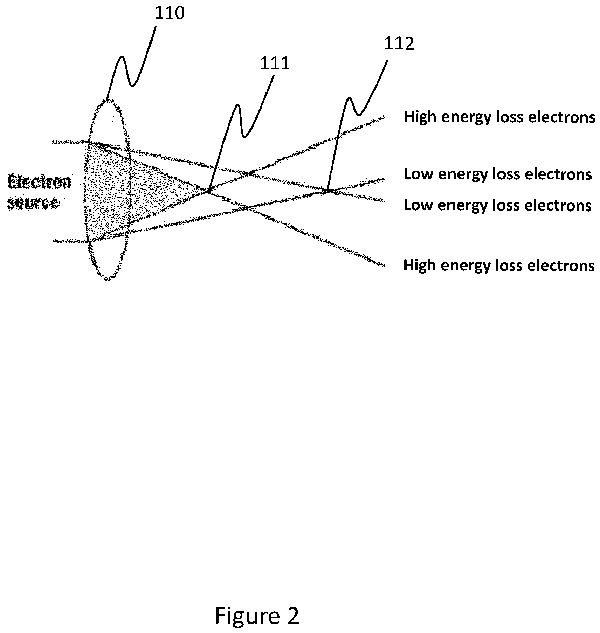

As noted above, when EELS spectrometers are used with very low camera lengths on the S/TEM so as to allow detection of large collection angles a parasitic defocus occurs as the objective lens of the S/TEM has chromatic aberration, that is a focal length that varies with electron energy. This effect is shown in FIG. 2, which shows the final crossover from the objective lens 110 at a first location 111 for high energy loss electrons and at a second position 112 for lower energy loss electrons.

The following equation describes the amount of defocus.

$$\Delta f = C_c \times \frac{\Delta E}{E} \times \theta_c \times \frac{L}{CL} \times \frac{M_s}{D_s}$$

Wherein:

$\Delta f$ = focus change (eV)
$C_c$ = Chromatic aberration (mm)
$E$ = Energy (eV)
$\Delta E$ = change in energy (eV)
$\theta_c$ = collection angle (rad)
$L$ = Distance from Projector Lens Cross-over to Aperture (mm)
$CL$ = Camera Length (mm)
$M_s$ = Spectrometer magnification
$D_s$ = Spectrometer dispersion (mm/eV)

In embodiments, electrostatic lenses 211, 212 located before the bending magnet 213, are used to not only correct any defocus from the drift tube (as previously described) but also to remove any defocus from the above-described chromatic effect in the S/TEM.

In embodiments, the chromatic defocus can be corrected by the lens or lenses 211, 212 for a first time in a calibration step and then this calibration value or values can be used for all future spectra having the same conditions. In embodiments, this method may be used to produce a well-focused spectrum image, which is a three-dimensional raster of points each with a spectrum across a two dimensional image.

In embodiments, at each S/TEM camera length, the effect of chromatic defocus is measured and a correction setting for a lens or lenses is determined for specific energy levels. System software is configured to store and recall the lens settings and to automatically apply the appropriate correction by reading the camera length and offset between two imaged spectrum portions energies and setting the lens element based on this stored calibration data for each imaged spectrum portion.

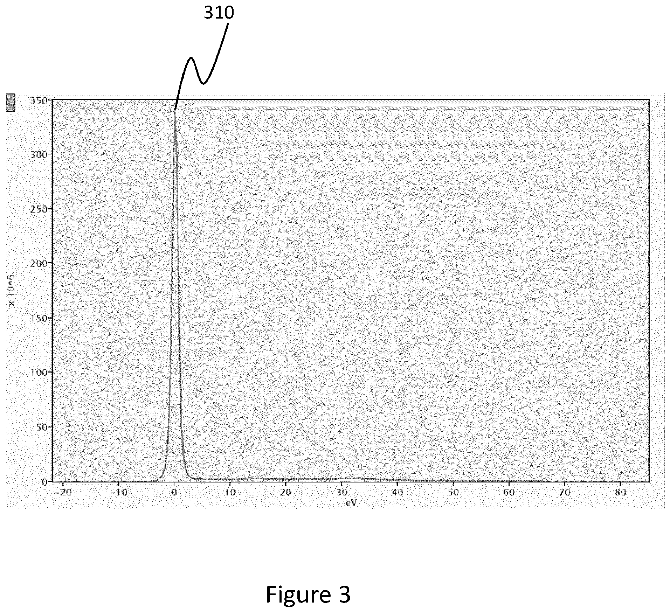

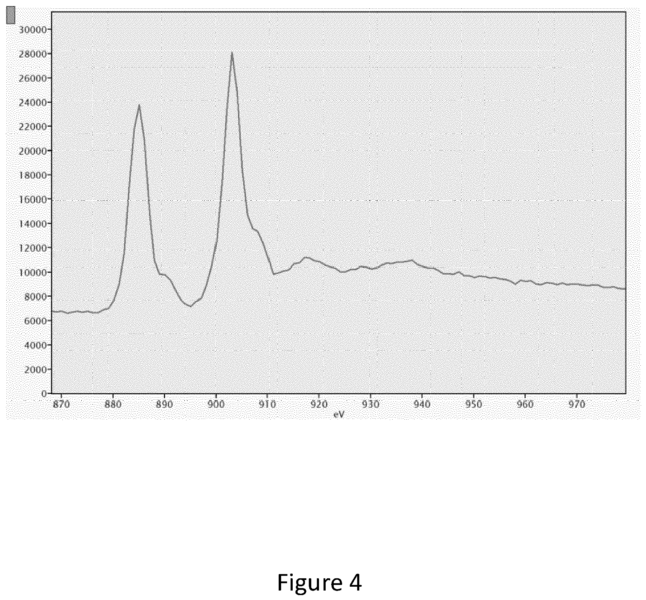

In this manner, rapid compensation for the chromatic aberration can be achieved so that multi-portion or multi-image spectra can be obtained comprising both a zero-loss 310 portion (shown e.g. FIG. 3) and an elemental edge portion (shown e.g. FIG. 4) which are separated in imaging time only by the speed of adjustment of the compensating lens or lenses or by the imaging sensor acquisition speed.

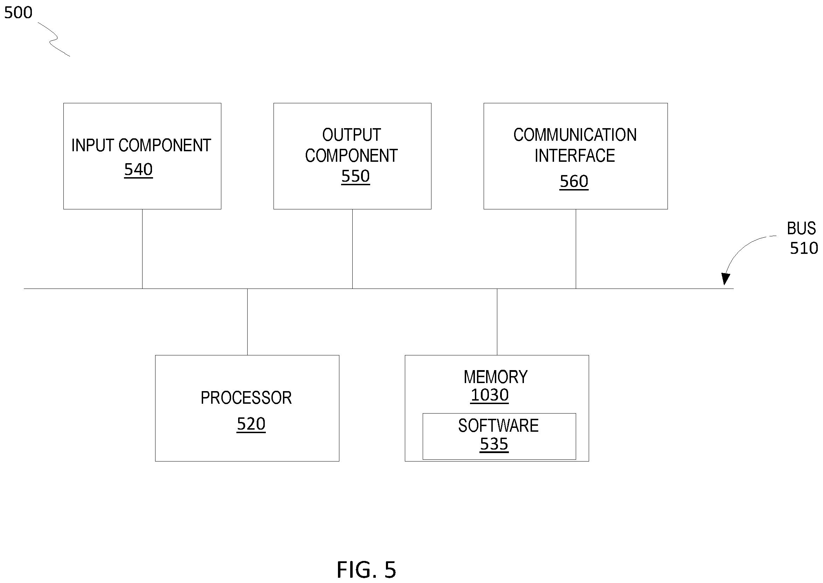

FIG. 5 is a diagram illustrating exemplary physical components of a device 500. Device 500 may correspond to various devices within the above-described system, such as system controller 230. Device 500 may include a bus 510, a processor 520, a memory 530, an input component 540, an output component 550, and a communication interface 560.

Bus 510 may include a path that permits communication among the components of device 500. Processor 520 may include a processor, a microprocessor, or processing logic that may interpret and execute instructions. Memory 530 may include any type of dynamic storage device that may store information and instructions, for execution by processor 520, and/or any type of non-volatile storage device that may store information for use by processor 520.

Software 535 includes an application or a program that provides a function and/or a process. Software 535 is also intended to include firmware, middleware, microcode, hardware description language (HDL), and/or other form of instruction. By way of example, with respect to the network elements that include logic to provide proof of work authentication, these network elements may be implemented to include software 535. Additionally, for example, device 500 may include software 535 to perform processes and methods as described herein.

Input component 540 may include a mechanism that permits a user to input information to device 500, such as a keyboard, a keypad, a button, a switch, etc. Output component 550 may include a mechanism that outputs information to the user, such as a display, a speaker, one or more light emitting diodes (LEDs), etc.

Communication interface 560 may include a transceiver that enables device 500 to communicate with other devices and/or systems via wireless communications, wired communications, or a combination of wireless and wired communications. For example, communication interface 560 may include mechanisms for communicating with another device or system via a network. Communication interface 560 may include an antenna assembly for transmission and/or reception of RF signals. In one implementation, for example, communication interface 560 may communicate with a network and/or devices connected to a network. Alternatively or additionally, communication interface 560 may be a logical component that includes input and output ports, input and output systems, and/or other input and output components that facilitate the transmission of data to other devices.

Device 500 may perform certain operations in response to processor 520 executing software instructions (e.g., software 535) contained in a computer-readable medium, such as memory 530. A computer-readable medium may be defined as a non-transitory memory device. A non-transitory memory device may include memory space within a single physical memory device or spread across multiple physical memory devices. The software instructions may be read into memory 530 from another computer-readable medium or from another device. The software instructions contained in memory 530 may cause processor 520 to perform processes described herein. Alternatively, hardwired circuitry may be used in place of or in combination with software instructions to implement processes described herein. Thus, implementations described herein are not limited to any specific combination of hardware circuitry and software.

Device 500 may include fewer components, additional components, different components, and/or differently arranged components than those illustrated in FIG. 5. As an example, in some implementations, a display may not be included in device 500. In these situations, device 500 may be a "headless" device that does not include input component 540. Additionally, or alternatively, one or more components of device 500 may perform one or more tasks described as being performed by one or more other components of device 500.

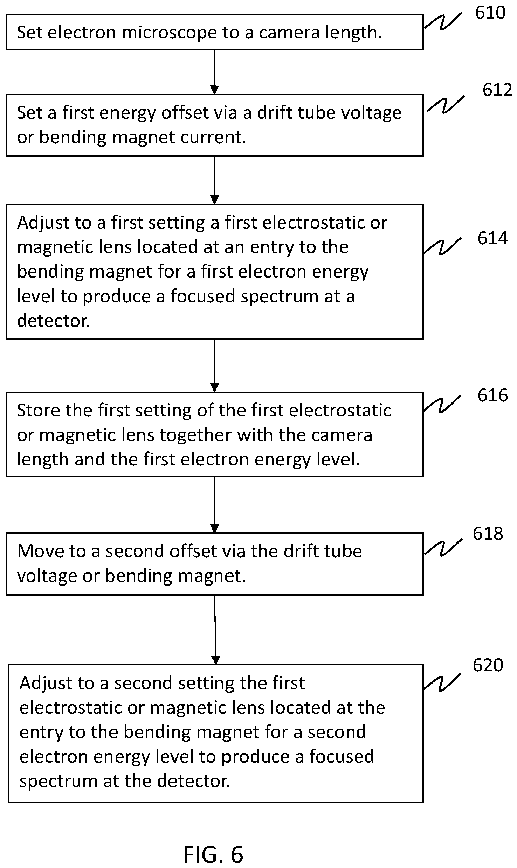

An exemplary process for compensating for chromatic aberration in an electron energy loss spectroscopy system comprising an electron microscope, a bending magnet, and a drift tube, is described with reference to FIG. 6. At 610, the electron microscope is set to a camera length. At 612, a first energy offset is set via a drift tube voltage or bending magnet current. At 614, a first electrostatic or magnetic lens located at an entry to the bending magnet is adjusted to a first setting for a first electron energy level to produce a focused spectrum at the detector. At 616 the first setting of the first electrostatic or magnetic lens is stored together with the camera length and the first electron energy level. At 618, the system is moved to a second offset via the drift tube voltage or bending magnet. At 620, the first electrostatic or magnetic lens located at the entry to the bending magnet is adjusted to a second setting for a second electron energy level to produce a focused spectrum at the detector.

In embodiments, there may be implemented a system for electron energy loss spectroscopy comprising: an electron microscope, a bending magnet, an electrostatic or magnetic lens located at an entrance end of the bending magnet, a controller configured to adjust the electrostatic or magnetic lens to compensate for a change in position of a final crossover of the electron beam in the electron microscope.

In further embodiments, the controller is configured to adjust the electrostatic or magnetic lens to a first setting associated with a first electron energy level and to a second setting associated with a second electron energy level.

In further embodiments, the adjustment to a first setting associated with a first electron energy level and to a second setting associated with a second electron energy level is a manually controlled adjustment.

In further embodiments, the adjustment to a first setting associated with a first electron energy level and to a second setting associated with a second electron energy level is an automatic adjustment based on stored calibration data.

In further embodiments, the adjustment to a first setting associated with a first electron energy level and to a second setting associated with a second electron energy level is an automatic adjustment based on stored calibration data and on a camera length of the electron microscope.

In embodiments there may be performed a method of compensating for chromatic aberration in an electron energy loss spectroscopy system comprising an electron microscope, a bending magnet, and a drift tube, the method comprising: setting the electron microscope to a camera length; setting a first energy offset via a drift tube voltage or bending magnet current; adjusting to a first setting a first electrostatic or magnetic lens located at an entry to the bending magnet for a first electron energy level to produce a focused spectrum at a detector; storing the first setting of the first electrostatic or magnetic lens together with the camera length and the first electron energy level; moving to a second offset via the drift tube voltage or bending magnet; and adjusting to a second setting the first electrostatic or magnetic lens located at the entry to the bending magnet for a second electron energy level to produce a focused spectrum at the detector.

In further embodiments, the method may include applying the stored first setting or a value calculated from the stored first setting to maintain focus of the spectrum for all subsequent spectra for any energy offset applied to the drift tube or bending magnet.

In further embodiments, the method may include repeating the steps of adjusting the electrostatic or magnetic lens for a plurality of electron energy levels and storing a plurality of settings, each associated with an electron microscope camera length and an electron energy level to create a calibration table.

In further embodiments, the method may include automatically adjusting the electrostatic or magnetic lens based on the electron microscope camera length, electron energy level and the calibration table.

## Claims

1. A system for electron energy loss spectroscopy comprising:

   an electron microscope,
   a bending magnet,
   an electrostatic or magnetic lens located at an entrance end of the bending magnet;
   a controller configured to adjust the electrostatic or magnetic lens to compensate for a change in position of a final crossover of the electron beam in the electron microscope.

2. The system of claim 1, wherein the controller is configured to adjust the electrostatic or magnetic lens to a first setting associated with a first electron energy level and to a second setting associated with a second electron energy level.

3. The system of claim 2, wherein the adjustment to a first setting associated with a first electron energy level and to a second setting associated with a second electron energy level is a manually controlled adjustment.

4. The system of claim 2, wherein the adjustment to a first setting associated with a first electron energy level and to a second setting associated with a second electron energy level is an automatic adjustment based on stored calibration data.

5.  The system of claim 2, wherein the adjustment to a first setting associated with a first electron energy level and to a second setting associated with a second electron energy level is an automatic adjustment based on stored calibration data and on a camera length of the electron microscope.

6.  A method of compensating for chromatic aberration in an electron energy loss spectroscopy system comprising an electron microscope, a bending magnet, and a drift tube, the method comprising:

setting the electron microscope to a camera length;
setting a first energy offset via a drift tube voltage or bending magnet current;
adjusting to a first setting a first electrostatic or magnetic lens located at an entry to the bending magnet for a first electron energy level to produce a focused spectrum at a detector;
storing the first setting of the first electrostatic or magnetic lens together with the camera length and the first electron energy level;
moving to a second offset via the drift tube voltage or bending magnet; and
adjusting to a second setting the first electrostatic or magnetic lens located at the entry to the bending magnet for a second electron energy level to produce a focused spectrum at the detector.

7.  The method of claim 6, further comprising:
applying the stored first setting or a value calculated from the stored first setting to maintain focus of the spectrum for all subsequent spectra for any energy offset applied to the drift tube or bending magnet.

8.  The method of claim 6, further comprising:
repeating the steps of adjusting the electrostatic or magnetic lens for a plurality of electron energy levels and storing a plurality of settings, each associated with an electron microscope camera length and an electron energy level to create a calibration table.

9.  The method of claim 8, further comprising:
automatically adjusting the electrostatic or magnetic lens based on the electron microscope camera length, electron energy level and the calibration table.

Figure 1

Figure 2

Figure 3

Figure 4

500

| INPUT COMPONENT<br>540 | | OUTPUT<br>COMPONENT<br>550 | | COMMUNICATION<br>INTERFACE<br>560 |

BUS
510

| PROCESSOR<br>520 | | MEMORY<br>1030 |
| | | SOFTWARE<br>535 |

FIG. 5

Set electron microscope to a camera length. /Ⅴ 610

Set a first energy offset via a drift tube voltage
or bending magnet current. /Ⅴ 612

Adjust to a first setting a first electrostatic or
magnetic lens located at an entry to the
bending magnet for a first electron energy
level to produce a focused spectrum at a
detector. /Ⅴ 614

Store the first setting of the first electrostatic
or magnetic lens together with the camera
length and the first electron energy level. /Ⅴ 616

Move to a second offset via the drift tube
voltage or bending magnet. /Ⅴ 618

Adjust to a second setting the first
electrostatic or magnetic lens located at the
entry to the bending magnet for a second
electron energy level to produce a focused
spectrum at the detector. /Ⅴ 620

FIG. 6

Europäisches
Patentamt

European
Patent Office

Office européen
des brevets

# EUROPEAN SEARCH REPORT

Application Number

EP 23 21 5840

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/096632 A1 (KAJI KAZUTOSHI [JP] ET AL) 25 July 2002 (2002-07-25) * paragraphs [0035] - [0061]; figures 1a,2 * | 1-9 | INV.<br>H01J37/05<br>H01J37/244<br><br>ADD.<br>H01J37/28 |
| X | EP 1 110 232 B1 (GATAN INC [US]) 25 November 2009 (2009-11-25) | 1-3 | |
| A | * paragraphs [0034], [0046], [0060] - [0062], [0066] - [0075]; figures 1,9-11 * | 4-9 | |
| X | US 2011/240854 A1 (TERADA SHOHEI [JP] ET AL) 6 October 2011 (2011-10-06) | 1 | |
| A | * paragraph [0071]; figure 1 * | 2-9 | |
| A | US 2004/188608 A1 (KANEYAMA TOSHIKATSU [JP]) 30 September 2004 (2004-09-30) * paragraphs [0034], [0049] - [0071]; figure 8 * | 1-9 | |

TECHNICAL FIELDS
SEARCHED      (IPC)

H01J

The present search report has been drawn up for all claims

| Place of search | Date of completion of the search | Examiner |
|---|---|---|
| Munich | 30 April 2024 | Schmidt-Kärst, S |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 23 21 5840

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2024

| Patent document cited in search report | | Publication date | Patent family member(s) | | Publication date |
|---|---|---|---|---|---|
| US 2002096632 | A1 | 25-07-2002 | EP 1209720 | A2 | 29-05-2002 |
| | | | US 2002096632 | A1 | 25-07-2002 |
| | | | US 2004183011 | A1 | 23-09-2004 |
| | | | US 2006163479 | A1 | 27-07-2006 |
| EP 1110232 | B1 | 25-11-2009 | EP 1110232 | A1 | 27-06-2001 |
| | | | JP 2002523869 | A | 30-07-2002 |
| | | | US 6184524 | B1 | 06-02-2001 |
| | | | WO 0011702 | A1 | 02-03-2000 |
| US 2011240854 | A1 | 06-10-2011 | EP 2375436 | A1 | 12-10-2011 |
| | | | JP 5315033 | B2 | 16-10-2013 |
| | | | JP 2010140640 | A | 24-06-2010 |
| | | | US 2011240854 | A1 | 06-10-2011 |
| | | | WO 2010067512 | A1 | 17-06-2010 |
| US 2004188608 | A1 | 30-09-2004 | EP 1441382 | A2 | 28-07-2004 |
| | | | JP 3979945 | B2 | 19-09-2007 |
| | | | JP 2004227942 | A | 12-08-2004 |
| | | | US 2004188608 | A1 | 30-09-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63432581